# EUROPEAN PATENT APPLICATION

(11) **EP 4 401 323 A1**
(43) Date of publication of application: **17.07.2024**
(21) Application number: 23219526.3
(22) Date of filing: 21.12.2023
(51) Int. Cl.: H04B 1/16, H04B 1/30, H04L 27/02, H03M 1/06

(54) **RECEIVER CIRCUIT, CORRESPONDING SYSTEM AND METHOD**

(30) Priority: 16.01.2023 IT 202300000495
(71) Applicant: STMicroelectronics International N.V., 1228 Plan-les-Ouates, Geneva (CH)
(72) Inventor: SPINA, Nunzio, I-95100 Catania (IT); CASTORINA, Alessandro, I-95024 Acireale (Catania) (IT); PALMISANO, Giuseppe, I-95030 S.Giovanni La Punta (Catania) (IT)
(74) Representative: Bosotti, Luciano

(57) **Abstract**

A receiver circuit for use, for instance, in interchip data communication in the automotive sector comprises an envelope detector (M1, M2, R_{L1}, C_{ED}) configured to receive (RX1) an on-off keying, OOK signal modulated over a RF carrier. A differential stage (121, 122, R_{L2}) has a first input (V_{A}) coupled to the envelope detector (M1, M2, RL1, CED) and a second input (V_{B}) configured to receive a reference signal. A comparator (16) is coupled (14) to first (C) and second (D) output nodes of the differential stage (121, 122, R_{L2}) produces a PWM-modulated signal (PWM_{OUT}) having on and off times. Offset compensation circuitry comprises a first switch (S₁,Φ₁) to short-circuit the input to the envelope detector (M1, M2, R_{L1}, C_{ED}), a storage capacitor (C_{H}) coupled to the second input (V_{B}) of the differential stage (121, 122, R_{L2}) and a second switch (S₁,Φ2) to feed back to the storage capacitor (C_{H}) a signal (18) indicative of the difference between the first (C) and the second (D) output nodes of the differential stage (121, 122, R_{L2}), and a third switch (S₃,Φ₁) to short-circuit the input to the comparator (16) . Logic circuitry (100) activates the offset compensation circuitry in a sequence of phases comprising a start-up phase (SUP) and at least one standby phase (STBY) wherein the first (S₁,Φ₁), second (S₂,Φ₂) and third (S₃,Φ₁) switches are made conductive in the absence of the PWM-modulated signal (PWM_{OUT}), and a working phase (WP) alternating with the start-up phase (SUP) or the at least one standby phase (STBY) in the presence of the PWM-modulated signal (PWM_{OUT}) wherein the first (S₁,Φ₁), second (S₂,Φ₂) and third (S₃,Φ₁) switches are made conductive during off times (T₂) of the PWM-modulated signal (PWM_{OUT}).

## Description

### Technical field

The description relates to signal transmission.

Solutions as described herein can be applied, for instance, to transmission of signals between semiconductor chips or dice (oftentimes referred to as inter-chip data communication).

Gate drivers (e.g., for electric motor control), galvanically isolated interfaces, medical equipment, sensor networks and data communications in general are exemplary of possible applications of solutions as described herein.

### Background

Inter-chip data communication may involve transmitting a modulated radio-frequency, RF carrier between two (integrated circuit) semiconductors chips or dice: as used therein chip/chips and die/dice will be regarded as synonyms.

This type of communication may involve transmitting a low-level RF signal that is rectified at the receiver (e.g., via an envelope detector) and then amplified to be converted into a digital (pulse-width modulated) PWM signal. A final conversion (to recover output data that replicate the transmitted data) can be performed via a hysteresis comparator.

Offset phenomena such as, e.g., an offset voltage between the two inputs of a first amplifier in the receiver can adversely affect correct recovery of the PWM signal.

Adequate offset compensation is thus desirable in order to facilitate accurate demodulation at the receiver.

Document CN 114 884 522 A discloses a differential millimeter-wave communication architecture and electronic equipment. The architecture comprises a transmitting device which comprises an oscillator, a frequency multiplier, a first differential transformer, at least one drive amplification circuit and a power amplification circuit which are connected in sequence. The driving amplification circuit comprises a driving amplifier and a second differential transformer which are connected in sequence, the power amplification circuit comprises a power amplifier and a third differential transformer which are connected in sequence, the power amplifier comprises a signal switch, and the signal switch is connected with an on-off keying signal input end. The millimeter-wave front-end circuit with low power consumption and small area can be realized.

Document US 6 249 556 B1 discloses a method and apparatus for thresholding an input signal synchronous with a clock signal at a receiver. The input signal is compared with a threshold voltage to produce a difference signal. The difference signal is synchronized with the input signal to generate a feedback signal. The threshold voltage is adjusted based on the feedback signal.

Document EP 1 985 011 A2 (WO 2007/088127 A2) discloses providing gigabit-rate data transmission over wireless radio links, using carrier frequencies in the millimeter-wave range (>30 GHz). More specifically, a circuit for detection of amplitude-shift keyed (ASK) or other amplitude modulations (AM) which can be easily incorporated into an integrated circuit receiver system is described, making the receiver capable of supporting both complex IQ modulation schemes and simpler, non-coherent on-off or multiple-level keying signals. Several radio architectures are also described which, with the addition of a frequency discriminator network, have the capability of handling frequency shift keyed (FSK) or other frequency modulations (FM), as well as AM and complex IQ modulation schemes. These radio architectures support a wide variety of modulations by efficiently sharing detector hardware components. The architecture for supporting both quadrature downconversion and ASK/AM is described first, followed by the ASK/AM detector circuit details, then the AM-FM detector architecture, and finally the most general AM-FM/IQ demodulator system concept and the FSK/FM detector circuit details.

### Object and summary

Solutions as described herein aim at addressing the issue discussed in the foregoing.

Such an object can be achieved via a receiver circuit having the features set forth in the claims that follow.

One or more embodiments relate to a corresponding system. A system comprising two or more (integrated circuit) inter-communicating semiconductor chips or dice is exemplary of such system.

One or more embodiments relate to a corresponding method.

The claims are an integral part of the technical teaching provided in respect of the embodiments.

Solutions as described herein provide a self-calibration technique for offset compensation in an amplitude-shift keying (ASK) receiver wherein a low-level baseband signal is amplified.

Solutions as described herein involve a dynamic approach that facilitates dynamically compensating also an offset drift induced by a temperature change.

Solutions as described herein do not involve external or non-standard components and are suitable for implementation via CMOS integration technology (e.g., GaN or SiC technology for power MOSFET transistors).

Solutions as described herein provide a fully integrated solution for automatic and accurate analog self-calibration wherein manual and/or preliminary setting can be dispensed with.

Solutions as described herein do not involve an increased power consumption and can be implemented with negligible area occupation.

Solutions as described herein facilitate achieving package scale isolation with galvanic isolation implemented without using specific high-voltage (HV) components.

Solutions as described herein facilitate providing an inter-chip communication channel implemented via wireless RF transmission.

A judicious selection of the distance between two chips facilitates achieving higher isolation ratings (10-12 kV for reinforced isolation) and higher CMTI (> 100 kV): common mode transient immunity (CMTI) is defined as the maximum tolerable rate of rise or fall of a common mode voltage applied between two isolated circuits.

This greatly facilitates arranging two inter communicating chips or dice on two neigboring die pads in a same leadframe packaged in a same body of molding compound (package scale isolation).

Solutions as described herein employ a simple approach that can be adapted easily to different applications, offset values, and accuracy levels with a procedure that can start automatically at start-up.

Solutions as described herein provide a self-calibration technique for offset compensation in an, e.g., ASK receiver where a low base-band signal is amplified by adopting an analog dynamic approach that facilitates compensate dynamically also offset drifts induced by temperature.

### Brief description of the several views of the drawings

One or more embodiments will now be described, by way of example only, with reference to the annexed figures, wherein:
Figure 1 is generally illustrative of communication between two circuits using a galvanic isolation barrier,
Figure 2 is illustrative of a possible context of application of solutions as described herein,
Figure 3 is illustrative of inter-chip data communication,
Figure 4 is an exemplary diagram of a receiver circuit for on-off keying, OOK modulation,
Figure 5 is a diagram showing possible time behaviors of signals that may occur in a receiver circuit for OOK modulation as described herein,
Figure 6 is an exemplary diagram of a receiver circuit according to embodiments of the present description, and
Figure 7 is a circuit diagram of a digital control circuit that may be used in embodiments of the present description.

Corresponding numerals and symbols in the different figures generally refer to corresponding parts unless otherwise indicated.

The figures are drawn to clearly illustrate the relevant aspects of the embodiments and are not necessarily drawn to scale.

The edges of features drawn in the figures do not necessarily indicate the termination of the extent of the feature.

### Detailed description

In the ensuing description one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment" or "in one embodiment" that may be present in one or more points of the present description do not necessarily refer to one and the same embodiment.

Moreover, particular conformations, structures, or characteristics may be combined in any adequate way in one or more embodiments.

The headings/references used herein are provided merely for convenience and hence do not define the extent of protection or the scope of the embodiments.

For simplicity and ease of explanation, throughout this description, and unless the context indicates otherwise, like parts or elements are indicated in the various figures with like reference signs, and a corresponding description will not be repeated for each and every figure.

Also, throughout this description, a same designation may be used for brevity to designate:
a certain node or line and a signal occurring at that node or line, and/or
a certain component (e.g., a capacitor or a resistor) and an electrical parameter thereof (e.g., capacitance or resistance/impedance) .

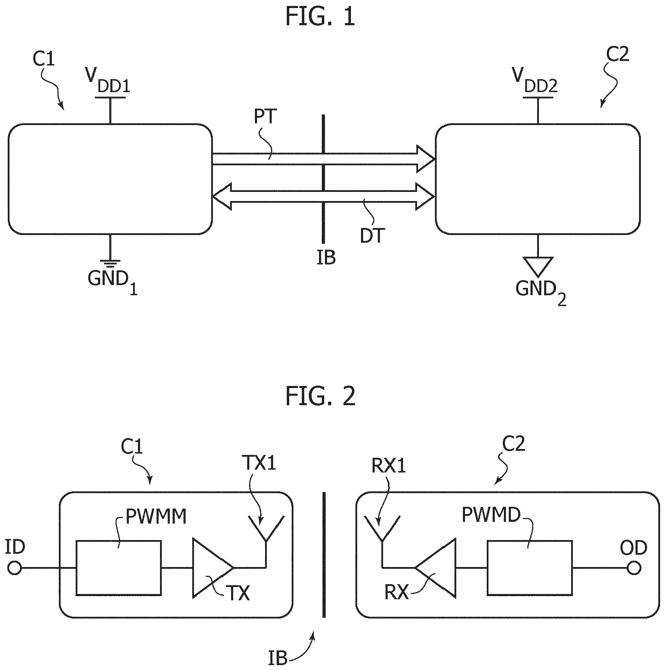

Figure 1 is generally illustrative of communication between two circuits C1 and C2 using a galvanic isolation barrier IB (a transformer, for instance).

As illustrated, the first circuit C1 has a supply voltage V_{DD1} and a (first) ground GND₁; the second circuit C2 has a supply voltage V_{DD2} and a (second) ground GND₂. The voltage V_{DD1} may be different from the voltage V_{DD2} and the ground GND₁ may be different from the ground GND₂, with possible ground shifts.

Communication as represented by the arrows can involve power transfer PT (e.g., from the circuit C1 to the circuit C2) and/or data transfer DT (e.g., from the circuit C1 to the circuit C2 and vice-versa).

The circuit C1 may comprise, just by way of example, human/data interfaces, bus/network controllers, microcontroller units (MCUs).

The circuit C2 may comprise, again just by way of example, sensor interfaces, gate drivers, intelligent power switches medical devices, a communication network.

Again, merely by way of example, a single-channel galvanic isolated gate driver can be used across a range of switching topologies to control power switches such as silicon-carbide (SiC) or silicon MOSFET transistors and IGBT insulated-gate bipolar transistors.

Figure 2 is illustrative of a possible context of application of solutions as described herein, wherein the circuits C1 and C2 are (integrated circuit) semiconductor chips or dice and communication between the two chips C1 and C2 involves transmitting input data ID from the chip C1 towards the chip C2 to be recovered as output data OD. As noted, this is just a non-limiting example in so far as communication between the two chips C1 and C2 may involve transmitting data ID from the chip C2 towards the chip C1, or communication in both directions.

In the following, transmission from the chip C1 towards the chip C2 will be referred to throughout for the sake of simplicity in order to avoid making the description unduly complicated.

Transmission as exemplified herein involves applying input data ID to a modulator (e.g., a pulse-width modulator) PWMM to produce a PWM-modulated signal that is applied to a transmitter TX for transmission via transmitter (micro)antenna TX1.

The transmitted signal is received via a receiver RX coupled to a receiver (micro) antenna RX1 to and transferred as a pulse-width modulated (PWM) signal to a demodulator (e.g., a pulse-width demodulator) PWMD to produce output data OD.

In certain applications as discussed in the following (these may be in the automotive sector, for instance) such an output PWM signal PWM_{OUT} can be used to drive an electronic switch such as, e.g., a power MOSFET transistor.

Various approaches (a transformer approach, a capacitive approach, an opto-coupler approach) can be resorted to in order to implement an arrangement as exemplified in Figure 2.

Solutions as described herein can be advantageously incorporated to the receiver RX as discussed in the following. To that effect, reinforced galvanic isolation interfaces (e.g., 10 kV) not bound to a specific integration technology is desirable.

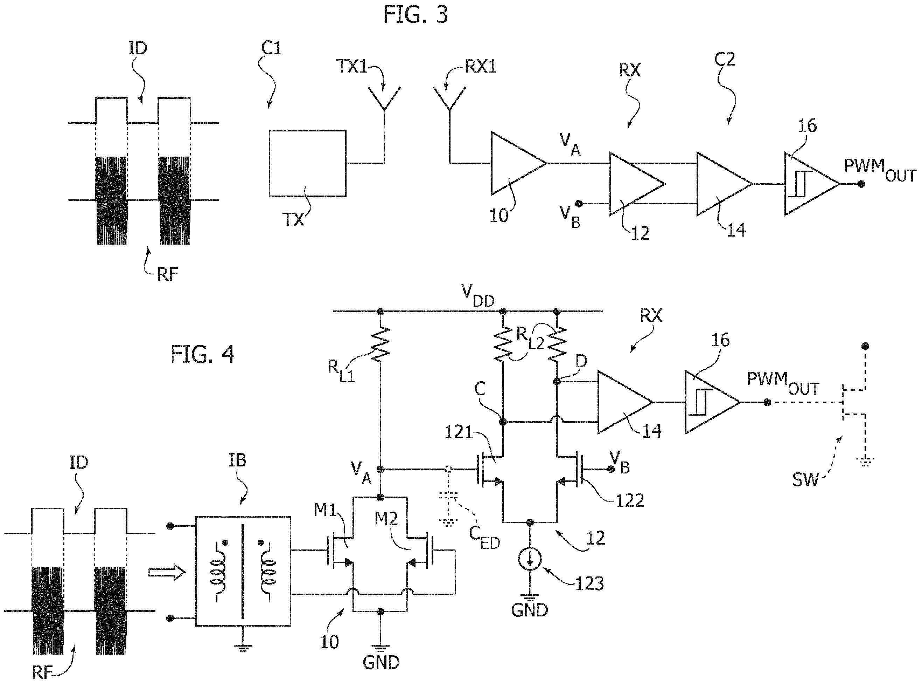

Figure 3 further illustrates inter-chip data communication under the, non-limiting, assumption that the input signal ID is a baseband binary signal that on-off modulates a radio-frequency carrier signal RF.

As illustrated in Figure 3, the receiver RX comprises an envelope detector 10 coupled to the receiver antenna RX1.

Figure 4 shows an envelope detector 10 implemented via two MOSFET transistors M1, M2 having their control terminals (gates, in the case of field-effect transistors such as MOSFETs) coupled to the galvanic barrier IB (e.g., across the secondary winding of a transformer providing the galvanic barrier IB) and the current flow paths therethrough (source-drain, in the case of a field-effect transistors such as MOSFETs) arranged in parallel in a current flow line between a supply line at a voltage V_{DD} and ground GND.

In certain embodiments, the flow of common-mode transient immunity (CMTI) currents towards ground can be facilitated by coupling the receiver RX in an AC (alternate current) mode to the antenna RX1 via two decoupling capacitances while a central socket of the antenna is connected to ground.

As illustrated in Figure 4, a resistor RL1 is arranged between the supply line V_{DD} and the parallel connection of the current flow paths through the MOSFET transistors M1, M2 with a (envelope) voltage V_{A} available at a corresponding node between the resistor RL1 and the MOSFET transistors M1, M2. Advantageously, a capacitor C_{ED} (shown in dashed lines) is coupled between the node V_{A} and ground (or between the node V_{A} and the line V_{DD}) to remove residues of the RF carrier from the signal obtained from the envelope detector 10.

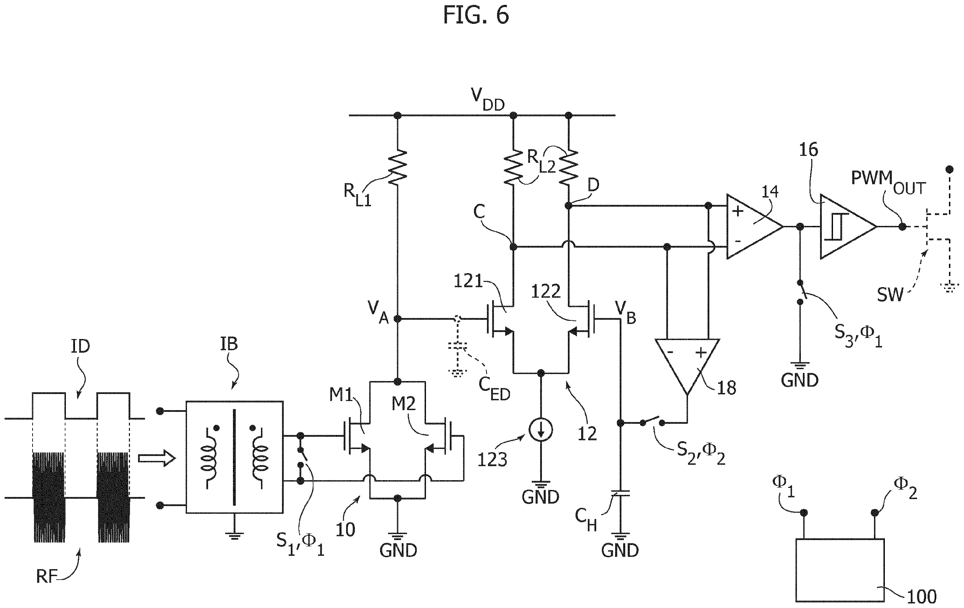

The one exemplified here (this also applies to the discussion of Figure 6 that follows) otherwise represents just one of a plurality of possible implementations of an envelope detector known to those of skill in the art that may resorted to within the framework of a solution as discussed herein.

Turning back to the more general representation of Figure 3, the envelope detector 10 (however implemented) is coupled to a first input (node V_{A}) of a differential amplifier 12 having a second input at a value V_{B}.

As illustrated, the output from the differential amplifier 12 is coupled (e.g., via a further amplifier 14 providing additional gain) to a (hysteresis) comparator 16 whose output is a PWM-modulated signal PWM_{OUT} suited to drive a load, e.g., to on-off turn an electronic switch SW such as a power MOSFET transistor.

It is noted that the load (e.g., the switch SW) is usually a distinct element from the embodiments.

In inter-chip data communication as illustrated in Figure 3 two micro-antennas TX1, RX1 are used to transmit a modulated RF carrier between two chips C1 and C2.

The low-level RF signal at the receiver is thus rectified (at the envelope detector 10) and then amplified (at the gain stages 12 and 14) to be applied to a hysteresis comparator 16 to provide an output PWM signal PWM_{OUT}.

An offset voltage between the two nodes V_{A}, V_{B} (the inputs to the amplifier 12) can adversely affect an even compromise a correct recovery of the PWM signal. Applying an offset compensation technique to compensate that offset voltage thus facilitates accurate demodulation of the PWM signal.

A related offset compensation circuit should desirably operate not only at start-up and standby conditions but also during operation in so far as this facilitates compensating offset drift effects.

Figure 4, already partly discussed, illustrates an exemplary diagram of a receiver circuit for on-off keying, OOK modulation, where the galvanic barrier IB is illustrated implemented as a transformer, and the envelope detector 10 is implemented via two MOSFET transistors M1, M2 having their control terminals (gates, in the case of field-effect transistors such as MOSFETs) coupled to the galvanic barrier IB (across the secondary winding of the transformer) and the current flow paths therethrough (source-drain, in the case of a field-effect transistors such as MOSFETs) arranged in parallel in a current flow line between a supply line at a voltage V_{DD} and ground GND.

As noted, a resistor R_{L1} is arranged between the supply line V_{DD} and the parallel connection of the current flow paths through the MOSFET transistors M1, M2, with the capacitor C_{ED} (shown in dashed lines) coupled between the node V_{A} and ground (or the line V_{DD}) to remove residues of the RF carrier from the signal from the envelope detector 10.

The envelope signal V_{A} between the resistor RL1 and the MOSFET transistors M1, M2 is applied to the input of the first amplifier stage 12 that comprises a differential pair of two (e.g., MOSFET) transistors 121, 122 having their control terminals (gates, in the case of field-effect transistors such as MOSFETs) coupled to receive the envelope signal V_{A} (at the control terminal of the transistor 121) and a reference signal V_{B} (at the control terminal of the transistor 122).

A tail current generator 123 is provided between the transistors 121, 122 and ground GND to be traversed by a current flowing through the parallel-connected current flow paths therethrough (source-drain, in the case of a field-effect transistors such as MOSFETs) through the transistors 121, 122.

Two resistors (both referenced as R_{L2}) are arranged coupled each between the supply line V_{DD} and:
a node C at the current flow path through the transistor 121, and
a node D at the current flow path through the transistor 122.

The output from the amplifier stage 12 is obtained as a differential signal between the nodes C and D and applied to the (differential) gain stage 14 to be then delivered to the input of the hysteresis comparator 16 that produces the output signal PWM_{OUT} the original PWM signal.

Various approaches can be considered for countering undesired offsets in a receiver as discussed previously.

A first approach may involve manual trimming using metal or "poly" fuses (eFuses). For instance, such fuses can replace the switches in the resistive string R_{L2} in Figure 4. Such an approach inevitably results in increase of the cost of in production testing. Also, high currents may be involved in blowing the fuse.

Another approach may involve using a floating gate MOSFET transistor to implement an analog trim-voltage memory (ATVM). Such an ATVM can be used for trimming offset voltages and currents resulting from threshold mismatches in analog circuits such as operational amplifiers and comparators. It can be incorporated into a standard digital CMOS process without additional processing steps as those currently involved in EEPROM fabrication. However, it still involves the non-negligible provision of additional elements.

Still another approach may involve using a one-time programmable (OTP) non-volatile memory (NVM) such an e-fuse or antifuse to replace floating-gate or e-fuse techniques as sued in analog/sensor trimming and calibration. Macros of the OTP type offer a good deal of security, reliability and flexibility as desirable to cost-effectively implement analog trimming and calibrate operations in consumer, automotive and mobile communication devices (ADC, receivers etc.). Also, die area occupation of an OTP element is small, and this reduces cost.

A drawback of this approach lies in the need for an initial programming phase either after chip packaging or by the user.

A still further approach may involve digital offset cancellation in a self-calibration technique: this approach is not able to support satisfactorily various operation phases such as start-up, working (operation proper) and standby as desirable for gate drivers. Applications with higher PWM rates (e.g., PWM rates higher than 400 KHz) are not compatible with PWM data transmission.

In solution as described herein an offset compensation solution is proposed based on a mixed analog/digital offset compensation strategy that is capable of tracking process, voltage and temperature (PVT) variations during different operating conditions, e.g., start-up, working, and standby conditions.

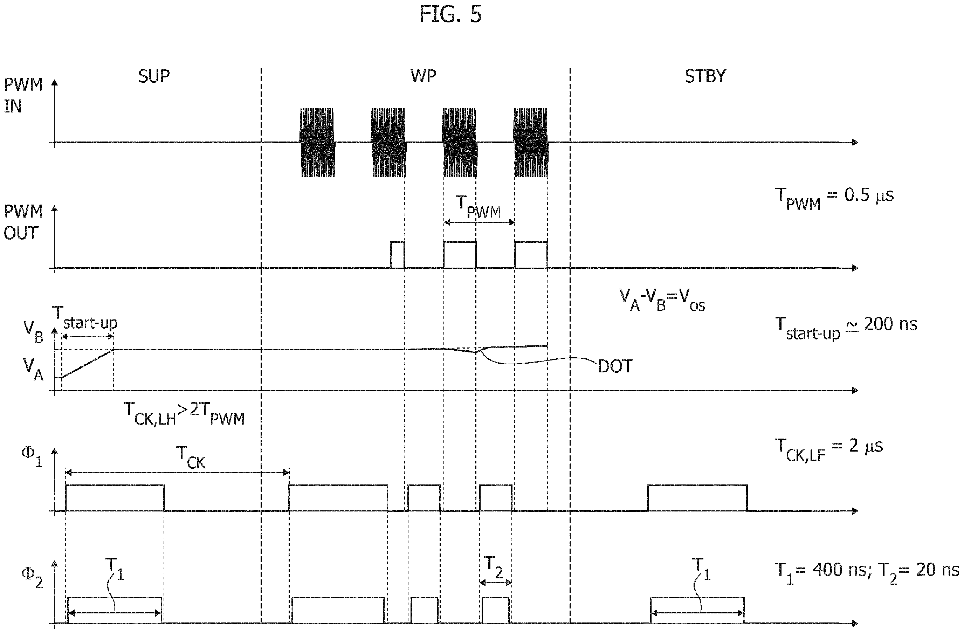

Figure 5 is a diagram showing, with reference to a common time (abscissa) scale, possible time behaviors of signals that may occur in a receiver circuit for OOK modulation.

More specifically, Figure 5 is a diagram showing possible time behaviors of the following signals (from top to bottom):
a PWM input signal PWM IN (modulated onto a RF carrier);
a corresponding PWM output signal PWM_{OUT};
a possible offset signal V_{OS} = V_{A} - V_{B} between the nodes V_{A} and V_{B}; and
two compensation control signals Φ₁ and Φ₂ produced as discussed in the following.

Specifically, possible time behaviors of the signals identified above are shown (from left to right) with reference to three different phases:
a start-up phase SUP, without any PWM signal assumed to be applied to the receiver;
a working phase WP, with a PWM (e.g., data) signal assumed to be applied to the receiver;
a stand-by phase STBY, again without any PWM signal assumed to be applied.

Merely by way of example (and without limitations for the embodiments) a period T_{PWM} of the PWM signal equal to 0.5 microseconds can be considered in connection with a start-up time Tₛₜₐᵣₜ₋ᵤₚ (the time for the signal V_{B} to initially reach the signal V_{A}) of 200 nanoseconds.

A dynamic offset compensation DOT (of a duration of about 20 nanoseconds) is shown in the curve for the possible offset signal V_{OS} = V_{A} - V_{B}.

The times T₁ (e.g., 400 nanoseconds) and T₂ (e.g., 20 nanoseconds) are shown in the two lowermost curves of Figure 5 for the two signals Φ₁ and Φ₂.

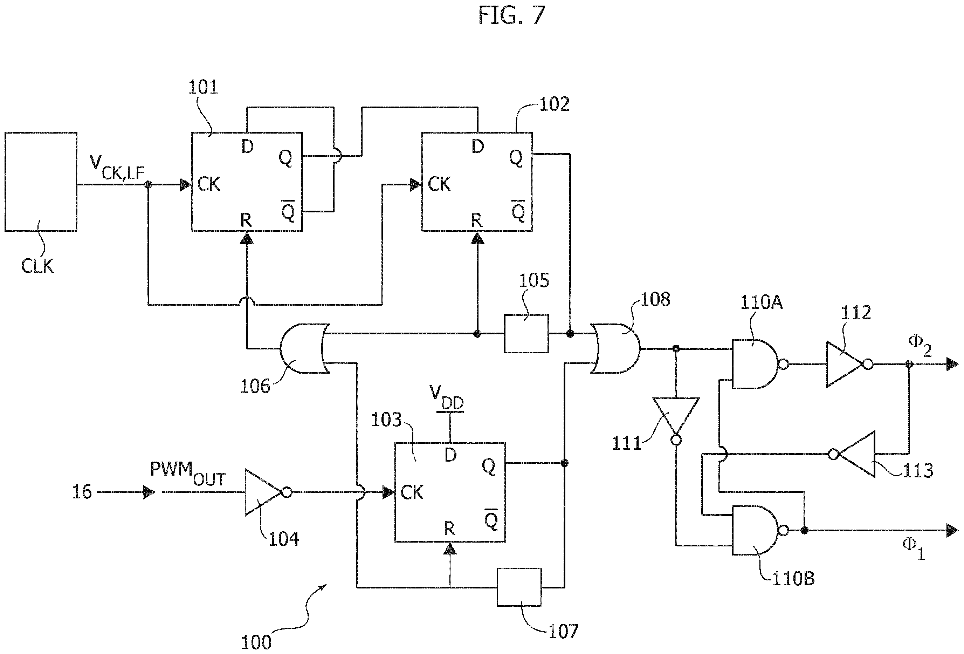

A time T_{CK,LF} such that T_{CK,LF}>2T_{PWM} (e.g. T_{CK,LF} equal to 2 microseconds) is also illustrated in connection with the clock signal V_{CK,LF} as discussed in Figure 7.

All of the quantitative figures referred to in the foregoing are merely exemplary and non-limiting: they are given primarily with the aim of elucidating certain relationships that may exist between the durations of various signals discussed herein.

Figure 6 is exemplary of an arrangement as presented in Figure 4 that is capable of operating adequately in (all of) the three operating phases SUP, WP and STBY presented in Figure 5.

In Figure 6, parts or elements like parts or elements already discussed in connection with Figure 4 are indicated with like reference numbers/symbols and a corresponding detailed description will not be repeated for brevity.

Also, like parts or elements being indicated with like reference numbers/symbols in Figure 4 and Figure 6 does not imply that these parts or elements need be implemented in the same manner in in both cases.

To summarize, the circuit illustrated in Figure 6 comprises:
an envelope detector M1, M2, R_{L1}, C_{ED} configured to receive (via the antenna RX1) an on-off keying, OOK signal modulated over a radiofrequency, RF carrier and remove therefrom the RF carrier,
a differential stage 121, 122, R_{L2} having a first input V_{A} coupled to the envelope detector M1, M2, RL1, C_{ED} and a second input V_{B} configured to receive a reference signal.

As illustrated, the differential stage 121, 122, R_{L2} has first C and second D output nodes configured to produce across them a replica of the OOK signal having the RF carrier removed therefrom

As illustrated, the circuit in Figure 6 comprises a comparator 16 coupled (e.g., via a gain stage 14) to the first C and second D output nodes of the differential stage 121, 122, R_{L2} and configured to produce, based on the replica of the OOK signal having the RF carrier removed therefrom, a PWM-modulated signal PWM_{OUT} having on and off times.

Comparing the circuit diagram of Figure 6 with the circuit diagram of Figure 4 shows that, in the circuit diagram of Figure 6:
a capacitor C_{H} is coupled between the node V_{B} (control terminal of the transistor 122) and ground GND;
a differential amplifier 18 is optionally coupled with its inputs (inverting, "-" and non-inverting, "+") coupled to the nodes C and D to provide additional (loop) gain to the difference between the voltages at these nodes (offset compensation as discussed in the following involves feeding this difference back to the node V_{B} targeting a zero value).

Comparing the circuit diagram of Figure 6 with the circuit diagram of Figure 4 also shows that, in the circuit diagram of Figure 6 three switches S₁,Φ₁, S₂,Φ₂ and S₃,Φ₁ (e.g., electronic switches such as MOSFET transistors) are provided configured, when "on" (that is when made conductive):
to short-circuit the output from the isolation barrier, namely the input to the envelope detector 10 (transistors M1, M2) of the receiver (switch S₁,Φ₁ - driven via the signal Φ₁);
to couple the node V_{B} (that is the capacitor C_{H}) to the output from the amplifier 18 to apply there to a signal indicative of the difference between the voltages at the nodes C and D (switch S₂,Φ₂ - driven via the signal Φ₂); and
to short towards ground GND the line coupling the amplifier 14 and the hysteresis comparator 16 (switch S₃,Φ_{1 -} driven via the signal Φ₁),

Operation (on-off switching) the switches S₁,Φ₁, S₂,Φ₂ and S₃,Φ₁ is controlled via the signals Φ₁ and Φ₂. These signals can be produced via a signal generator 100 as illustrated in the diagram of Figure 7.

It is noted that the switches S₁,Φ₁ and S₃,Φ₁ are controlled via the signal Φ₁, while the switch S₂,Φ₂ is controlled via the signal Φ₂.

It is otherwise noted that (as visible in the two lowermost curves in the diagram of Figure 5) the signals Φ₁ and Φ₂ have corresponding time behaviors (that is, essentially the same time behavior) with the exception that the signal Φ₂ has:
rising edges (slightly) lagging (i.e., following) the rising edges of the signal Φ₁, and
falling edges (slightly) preceding (i.e., anticipating) the falling edges of the signal Φ₁.

This kind of "dis-overlapping" advantageously counters undesired effects of the transmitted PWM signal on offset compensation, e.g., facilitating the PWM signal in being at a "low" level (switch SW turned off) during offset compensation.

Undesired inaccuracies in offset compensation during the start-up (SUP) and standby (STBY) phases are countered in so far the receiver input is short-circuited by the switch S₁,Φ₁ and the input to the comparator 16 is forced to zero (GND) by the switch S₃,Φ₁ so that no PWM signal (and also no input noise) propagates through the receiver. Also, offset compensation during the working phase (WP), when a PWM signal is expected to propagate through the receiver, is effected during the "off" times of the PWM signal, that is when the PWM signal is at zero level.

The arrangement of Figure 6 is thus exemplary of a compensation loop that exploits the first amplifier of the receiving chain (transistors M1 and M2) as an input stage and the second stage (transistors 121, 122) to increase gain.

Such an arrangement is advantageous. e.g., with GaN technologies that have offsets (much) higher than CMOS technologies and deserve not to be neglected with respect to typical variations in the bias voltage V_{A}.

Advantageously, the arrangement of Figure 6 (and Figure 7) facilitates dynamic adaptative operation that uses two timing (clock) signals, one of which is synchronized to the PWM signal, with two compensation time slots.

As illustrated herein, this result is facilitated by a mixed analog/digital compensation approach, which combines analog compensation and digital control.

A possible implementation of the generator 100 (this may be either a distinct circuit or be incorporated to a single circuit with the receiver of Figure 6) is built around three D-type flip-flops 101, 102, and 103.

The two first flip-flops 101, 102 are clocked via a clock signal V_{CK,LF} (generated with a clock generator CLK of any type known to those of skill in the art, e.g., a ring oscillator: this may possible be a distinct element from the embodiments) with a period T_{CK,LF} such that T_{CK,LF}>2T_{PWM} as illustrated in the diagram of Figure 5.

The third flip-flop 103 is clocked via the PWM signal PWM_{OUT} from the comparator 16 (logically inverted at an inverter 104) or any other signal synchronous with such a PWM signal. Essentially, as discussed in the following, the signal V_{CK,LF} can be regarded as a (e.g., square wave) signal that is "slow" with respect to the PWM signal.

As illustrated in Figure 7:
the first flip-flop 101 is arranged with its (negated) Q output coupled to its D input and the Q output coupled to the D input to the second flip-flop 102;
the Q output from the second flip-flop 102 is fed back via a (first) delay block 105 to the reset input R of the second flip-flop 102 and to a first input of a (first) OR gate 106 that drives the reset input R of the first flip-flop 101;
the third flip-flop 103 is arranged with its D input set to the supply voltage VDD and the Q output fed back via a (second) delay block 107 to the reset input R of the third flip-flop 103 and to the other input of the OR gate 106 that drives the reset input R of the first flip-flop 101;
the Q outputs of the second and third flip-flops 102 and 103 are applied to the inputs of a (second) OR gate 108, whose output drives a pair of NAND gates 110A, 110B;
the first NAND gate 110A receives, on a first input, the output of the OR gate 108 and, on a second input, the output of the second of NAND gate 110B; and
the second NAND gate 110B receives, on a first input, the output of the OR gate 108 logically inverted at an inverter 111 and, on a second input, the output of the first NAND gate 110A (as obtained via two complementary logical inversions at two inverters 112 and 113.

The delay blocks 105 and 107 thus dictate the characteristics of the signals Φ₁ and Φ₂ (primarily the durations of the intervals T₁ and T₂).

As noted, the one illustrated in Figure 7 is only one exemplary implementation of a signal generator 100 configured to provide the signals Φ₁ (at the output of the second NAND gate 110B) and Φ₂ (at the output of the first NAND gate 110A after logical inversion at the inverter 112), namely two slightly "dis-overlapped" replicas Φ₁ and Φ_{2 of} a same signal in order to counter undesired effects of the transmitted PWM signal on offset compensation: other implementations are within the ability of those of skill in the art.

To summarize, the one illustrated in Figure 7 is an exemplary implementation of a signal generator 100 configured provide signals Φ₁ and Φ₂ that make the first switch S₁,Φ₁, the second switch S₂,Φ₂ and the third switch S₃,Φ₁ conductive during the start-up phase SUP and (at least one) standby phase STBY for a time T₁ longer than the off times T₂ of the PWM-modulated signal.

In the examples considered herein the PWM-modulated signal PWM_{OUT} has a period (e.g., T_{PWM} = 0.5 microseconds) and the logic circuitry 100 is configured to make the first switch S₁,Φ₁, the second switch S₂,Φ₂ and the third switch S₃,Φ₁ conductive during the start-up and standby phases for a time T₁ (e.g., 400 nanoseconds) that is at least one order of magnitude (that, is at least ten times) longer than the off times T₂ (e.g., 20 nanoseconds) of the PWM-modulated signal.

As exemplified in Figure 7, the logic circuitry 100 comprises:
a first branch (e.g., the integers 101, 102, 105) configured to be activated during the start-up and the standby phases to make the switches S₁,Φ₁; S₂,Φ₂, and S₃,Φ₁ conductive in the absence of the PWM-modulated signal PWM_{OUT} as a function of a first clock signal V_{CK,LF}, and
a second branch (e.g., the integers 103, 107) configured to be activated during the working phase WP to make the switches S₁,Φ₁; S₂,Φ₂, and S₃,Φ₁ conductive during off times T₂ of the PWM-modulated signal.

As illustrated, the circuit comprises a clock generator CLK (optionally a ring oscillator) to produce the first clock signal V_{CK,LF} to activate the first branch 101, 102 of the logic circuitry 100 and make the switches S₁,Φ₁, S₂,Φ₂, and S₃,Φ₁, conductive (even) in the absence of the PWM-modulated signal PWM_{OUT}.

As illustrated, the second branch 103, 107 of the logic circuitry 100 is coupled to the comparator 16 to receive therefrom the PWM-modulated signal PWM_{OUT} to make the switches S₁,Φ₁; S₂,Φ₂; and S₃,Φ₁, conductive during off times T₂ of the PWM-modulated signal.

As illustrated, the logic circuitry 100 is configured to produce:
a first drive signal Φ₁ to make the first switch S₁,Φ1 and the third switch S₃,Φ₁, conductive, and
a second drive signal Φ₂ to make the second switch S₂,Φ₂ conductive.

As illustrated, the first signal Φ₁ and the second signal Φ₂ exhibit corresponding (i.e., substantially identical, but slightly dis-overlapped) time behaviors with the second signal Φ₂ having rising edges lagging the rising edges of the first signal Φ₁ and falling edges preceding the falling edges of the first signal Φ₁.

As exemplified in the diagram of Figure 5, operation of the arrangement of Figure 6 (and Figure 7) involves, during a start-up phase SUP of the receiver, the storage capacitor C_{H} in Figure 6 (that provides the voltage V_{B}) being charged from an initial value towards the voltage V_{A}.

As visible on the left-hand side of the diagram for the voltage V_{B} in Figure 5 this process takes place "slowly" (due to slewing limitations) during a first charging pulse of duration T₁ that represents the compensation time slot during the start-up phase SUP (and also in stand-by conditions STBY, as discussed in the following).

To that purpose, the digital circuitry (e.g., essentially the generator 100, with the PWM signal not present yet) operates at low frequency clock signal (V_{CK,LF} having a frequency f_{CK,LF} of, e.g., 0.5 MHz) thus providing a large (long) compensation pulse T₁.

During the working phase WP (center portion of Figure 5), with the PWM signal present, the negative time slot of the PWM signal can be exploited to restore the capacitor C_{H} and thus compensate for offset variations due to thermal drift effects.

During the working phase WP, the clock of the digital circuit is switched from the previous low-frequency clock to a clock that is extracted from the PWM signal (e.g., with a frequency f_{PWM} = 2 MHz). A narrow pulse (about 20 ns, for instance) is then generated for dynamic offset compensation (DOT in the diagram of Figure 5) that is suitable for the compensation even for high values for the duty cycle (e.g., 90%) when the negative time slot of the PWM signal is low (i.e., 50 ns).

It is noted that, during the working phase WP as represented in Figure 5, the PWM signal PWM_{OUT} is at first "blanked" as a result of the switches S₁,Φ₁ and S₃,Φ₁ being still closed by the signal Φ1.

It is noted that the highest number of PWM pulses that can be lost during compensation in the start-up and/or standby phases (SUP and STBY, respectively) due to offset compensation is equal to f_{PWM}/2f_{CK,LF} (e.g., 2 in the exemplary implementation presented herein).

During the standby phase STBY (right-hand portion of Figure 5), where the PWM signal is no longer transmitted, the clock signal is again switched to the low frequency clock. For instance, this may happen if the PWM signal is not present for a time higher than T_{CK,LF}.

It will be appreciated that, while a sequence of a start-up phase SUP, a working phase WP and standby phase STBY is illustrated in Figure 5, operation of a receiver as discussed herein may involve, after a start-up phase SUP, an alternation of working phases WP and standby phases STBY depending on whether a PWM signal is transmitted or not.

It is once more noted that the highest number of PWM pulses that can be lost as a result of compensation during in the start-up and/or standby phases (SUP and STBY, respectively) - see the left-hand side of the central portion in Figure 5, where the PWM signal is initially blanked - is equal to f_{PWM}/2f_{CK,LF} (e.g., 2 in the exemplary implementation presented herein.

To summarize, a solution as proposed herein comprises offset compensation circuitry including:
a first switch S₁,Φ₁ operable to be made conductive to short-circuit the input to the envelope detector M1, M2, R_{L1}, C_{ED},
a storage capacitor C_{H} coupled to the second input V_{B} of the differential stage 121, 122, R_{L2},
a second switch S₂,Φ₂ operable to be made conductive to feed back to the storage capacitor C_{H} a signal (e.g., from the differential stage 18) indicative of the difference between the first output node C and the second D output node of the differential stage 121, 122, R_{L2}, and
a third switch S₃,Φ₁, operable to be made conductive to short-circuit the input to the comparator 16.

The logic circuitry 100 as exemplified in Figure 7 is configured to activate the offset compensation circuitry in a sequence of phases comprising, in the first place a start-up phase SUP where the switches S₁,Φ₁; S₂,Φ₂, and S₃,Φ₁ are made conductive in the absence of the PWM-modulated signal PWM_{OUT}.

Once the start-up phase completed, the logic circuitry 100 as exemplified in Figure 7 is configured to activate a working phase WP in the presence of the PWM-modulated signal PWM_{OUT} where the switches S₁,Φ₁; S₂,Φ₂, S₃,Φ₁, are made conductive during off times T₂ of the PWM-modulated signal PWM_{OUT}.

A standby phase STBY may then follow where the switches S₁,Φ₁; S₂,Φ₂, and S₃,Φ₁, are again made conductive in the absence of the PWM-modulated signal PWM_{OUT}, with the circuit returning from the standby phase to working phase in response to a PWM (OOK) signal being again received via the antenna RX1. Consequently, the working phase WP can be regarded as a phase alternating with the start-up phase SUP and/or at least one standby phase STBY.

As discussed, a (further) differential stage 18 can be advantageously coupled across the first output node C and the second D output node of the differential stage 121, 122, R_{L2} to apply a (loop) gain to the signal indicative of the difference between the first output node C and the second output node D of the differential stage 121, 122, R_{L2} that is fed back to the storage capacitor C_{H}. This option is found to facilitate proper operation of the compensation loop with the target of keeping at zero the difference of the voltages at the nodes C and D.

As discussed, a (further) gain stage 14 is optionally arranged between the differential stage 121, 122, R_{L2} and the comparator 16 with the purpose of applying a (transfer) gain to the replica of the OOK signal having the RF carrier removed that is applied to the comparator 16 to produce the PWM-modulated signal PWM_{OUT}.

This option is found to facilitate proper operation of the comparator in the presence of small (weak) input signals to the receiver.

A solution as proposed herein is able to operate adequately in (all of) the three operating phases SUP, WP, and STBY illustrated in the diagram of Figure 5. This result is facilitated by the use of two clock signals (one of which is synchronized to the transmitted signal) and two compensation time slots.

Without prejudice to the underlying principles, the details and embodiments may vary, even significantly, with respect to what has been described by way of example only without departing from the extent of protection. The extent of protection is determined by the annexed claims.

## Claims

1. A circuit, comprising:
an envelope detector (M1, M2, R_{L1}, C_{ED}) configured to receive (RX1) an on-off keying, OOK signal modulated over a radiofrequency, RF carrier and remove therefrom the RF carrier,
a differential stage (121, 122, R_{L2}) having a first input (V_{A}) coupled to the envelope detector (M1, M2, RL1, CED) and a second input (V_{B}) configured to receive a reference signal, the differential stage (121, 122, R_{L2}) having first (C) and second (D) output nodes configured to produce therebetween a replica of the OOK signal having the RF carrier removed therefrom, and
a comparator (16) coupled (14) to the first (C) and second (D) output nodes of the differential stage (121, 122, R_{L2}) and configured to produce, based on said replica of the OOK signal having the RF carrier removed therefrom, a PWM-modulated signal (PWM_{OUT}) having on and off times,
wherein the circuit comprises:
offset compensation circuitry including a first switch (S₁,Φ₁) operable to be made conductive to short-circuit the input to the envelope detector (M1, M2, R_{L1}, C_{ED}), a storage capacitor (C_{H}) coupled to the second input (V_{B}) of the differential stage (121, 122, R_{L2}) as well as a second switch (S₁,Φ₂) operable to be made conductive to feed back to the storage capacitor (C_{H}) a signal (18) indicative of the difference between the first output node (C) and the second (D) output node of the differential stage (121, 122, R_{L2}), and a third switch (S₃,Φ₁) operable to be made conductive to short-circuit the input to the comparator (16), and
logic circuitry (100) configured to activate the offset compensation circuitry in a sequence of phases comprising:
a start-up phase (SUP) and at least one standby phase (STBY) wherein the first switch (S₁,Φ₁), the second switch (S₂,Φ₂) and the third switch (S₃,Φ₁) are made conductive in the absence of the PWM-modulated signal (PWM_{OUT}), and
a working phase (WP) alternating with the start-up phase (SUP) or the at least one standby phase (STBY) in the presence of the PWM-modulated signal (PWM_{OUT}) wherein the first switch (S₁,Φ₁), the second switch (S₂,Φ₂) and the third switch (S₃,Φ₁) are made conductive during off times (T₂) of the PWM-modulated signal (PWM_{OUT}),
wherein the circuit comprises a gain stage (14) arranged between the differential stage (121, 122, RL2) and the comparator (16) configured to apply a transfer gain to said replica of the OOK signal having the RF carrier removed therefrom applied to the comparator to produce the PWM-modulated signal (PWMOUT) having on- and off-times.

2. The circuit of claim 1, wherein the logic circuitry (100) is configured to make the first switch (S₁,Φ₁), the second switch (S₂,Φ₂) and the third switch (S₃,Φ₁) conductive during the start-up phase (SUP) and the at least one standby phase (STBY) for a time (T₁) longer than the off times (T₂) of the PWM-modulated signal.

3. The circuit of claim 2, wherein the PWM-modulated signal (PWM_{OUT}) has a period (T_{PWM}) and the logic circuitry (100) is configured to make the first switch (S₁,Φ₁), the second switch (S₂,Φ₂) and the third switch (S₃,Φ₁) conductive during the start-up phase (SUP) and the at least one standby phase (STBY) for a time (T₁) at least one order of magnitude longer than the off times (T₂) of the PWM-modulated signal.

4. The circuit of any of the previous claims, wherein the logic circuitry (100) comprises:
a first branch (101, 102, 105) configured to be activated during the start-up phase (SUP) and the at least one standby phase (STBY) to make the first switch (S₁,Φ₁), the second switch (S₂,Φ₂) and the third switch (S₃,Φ₁) conductive in the absence of the PWM-modulated signal (PWM_{OUT}) as a function of a first clock signal (V_{CK,LF}), and
a second branch (103, 107) configured to be activated during the working phase (WP) to make the first switch (S₁,Φ₁), the second switch (S₂,Φ₂) and the third switch (S₃,Φ₁) conductive during off times (T₂) of the PWM-modulated signal.

5. The circuit of claim 4, wherein:
the circuit comprises a clock generator (CLK), preferably a ring oscillator, configured to produce the first clock signal (V_{CK,LF}) to activate the first branch (101, 102) of the logic circuitry (100) to make the first switch (S₁,Φ₁), the second switch (S₂,Φ₂) and the third switch (S₃,Φ₁) conductive in the absence of the PWM-modulated signal (PWM_{OUT}) and/or
the second branch (103, 107) of the logic circuitry (100) is coupled to said comparator (16) to receive therefrom said PWM-modulated signal (PWM_{OUT}) to make the first switch (S₁,Φ₁), the second switch (S₂,Φ₂) and the third switch (S₃,Φ₁) conductive during off times (T₂) of the PWM-modulated signal.

6. The circuit of any of the previous claims, wherein:
the logic circuitry (100) is configured to produce a first drive signal (Φ₁) to make the first switch (S₁,Φ₁) and the third switch (S₃,Φ₁) conductive and a second drive signal (Φ₂) to make the second switch S₂,Φ₂) conductive, and
the first signal (Φ₁) and the second signal (Φ₂) have corresponding time behaviors with the second signal (Φ₂) having rising edges lagging the rising edges of the first signal (Φ₁) and falling edges preceding the falling edges of the first signal (Φ₁) .

7. The circuit of any of the previous claims, comprising:
a further differential stage (18) coupled to the first output node (C) and the second (D) output node of the differential stage (121, 122, R_{L2}) and configured to apply a loop gain to the signal indicative of the difference between the first output node (C) and the second (D) output node of the differential stage (121, 122, R_{L2}) fed back to the storage capacitor (C_{H}) in response to the second switch (S₂,Φ₂) being made conductive.

8. The circuit of any of the previous claims, comprising an electronic switch (SW), preferably a power transistor, coupled to said comparator (16) and configured to be driven as a function of said PWM-modulated signal (PWM_{OUT}) .

9. A system comprising:
a plurality of semiconductor chips (C1, C2) configured to communicate via an on-off keying, OOK signal modulated over a radiofrequency, RF carrier, wherein at least one (C2) of the chips in the plurality comprises a circuit (RX) according to any of the preceding claims with said envelope detector (M1, M2, R_{L1}, C_{ED}) configured to receive (RX1) said OOK signal.

10. A method, comprising:
receiving an on-off keying, OOK signal modulated over a radiofrequency, RF carrier at an envelope detector (M1, M2, R_{L1}, C_{ED}) to remove the RF carrier from said OOK signal,
producing a replica of the OOK signal having the RF carrier removed therefrom between first (C) and second (D) output nodes of a differential stage (121, 122, R_{L2}) having a first input (V_{A}) coupled to the envelope detector (M1, M2, RL1, CED) and a second input (V_{B}) configured to receive a reference signal, and
producing, via a comparator (16) coupled (14) to the first (C) and second (D) output nodes of the differential stage (121, 122, R_{L2}), a PWM-modulated signal (PWM_{OUT}) having on and off times based on said replica of the OOK signal having the RF carrier removed therefrom,
wherein the method further comprises:
providing a first switch (S₁,Φ₁) operable to be made conductive to short-circuit the input to the envelope detector (M1, M2, R_{L1}, C_{ED}), a storage capacitor (C_{H}) coupled to the second input (V_{B}) of the differential stage (121, 122, R_{L2}) as well as a second switch (S₁,Φ₂) operable to be made conductive to feed back to the storage capacitor (C_{H}) a signal (18) indicative of the difference between the first output node (C) and the second (D) output node of the differential stage (121, 122, R_{L2}), and a third switch (S₃,Φ₁) operable to be made conductive to short-circuit the input to the comparator (16), and
activate a sequence of offset compensation phases comprising:
a start-up phase (SUP) and at least one standby phase (STBY) making the first switch (S₁,Φ₁), the second switch (S₂,Φ₂) and the third switch (S₃,Φ₁) conductive in the absence of the PWM-modulated signal (PWM_{OUT}), and
a working phase (WP) alternating with the start-up phase (SUP) or the at least one standby phase (STBY) in the presence of the PWM-modulated signal (PWM_{OUT}) making the first switch (S₁,Φ₁), the second switch (S₂,Φ₂) and the third switch (S₃,Φ₁) conductive during off times (T₂) of the PWM-modulated signal (PWM_{OUT}),
wherein the method comprises applying via a gain stage (14) arranged between the differential stage (121, 122, RL2) and the comparator (16) a transfer gain to said replica of the OOK signal having the RF carrier removed therefrom applied to the comparator to produce the PWM-modulated signal (PWMOUT) having on- and off-times.
